# EUROPEAN PATENT APPLICATION

(11) **EP 4 761 491 A1**
(43) Date of publication of application: **17.06.2026**
(21) Application number: 24864129.2
(22) Date of filing: 03.06.2024
(51) Int. Cl.: H10B 10/00

(54) **STATIC RANDOM ACCESS MEMORY ARRAY, MEMORY, AND ELECTRONIC DEVICE**

(30) Priority: 13.09.2023 CN 202311183082
(71) Applicant: HUAWEI TECHNOLOGIES CO., LTD., Shenzhen 518129 (CN)
(72) Inventor: JING, Weiliang, Shenzhen, Guangdong 518129 (CN); YIN, Shihui, Shenzhen, Guangdong 518129 (CN); ZHAO, Xiaoxuan, Shenzhen, Guangdong 518129 (CN); WU, Ying, Shenzhen, Guangdong 518129 (CN); WANG, Zhengbo, Shenzhen, Guangdong 518129 (CN); LIAO, Heng, Shenzhen, Guangdong 518129 (CN)
(74) Representative: Grünecker Patent- und Rechtsanwälte PartG mbB
(86) International application number: PCT/CN2024/097127
(87) International publication number: WO 2025/055404

(57) **Abstract**

This application provides a static random-access memory array, a production method for the static random-access memory array, a memory, and an electronic device, relates to the field of memory technologies, to improve memory density. The SRAM memory array includes a semiconductor substrate, a front-end-of-line device layer formed in the semiconductor substrate, and a back-end-of-line device layer stacked on the front-end-of-line device layer. The SRAM memory array further includes a plurality of memory cells. Each memory cell includes at least one P-type field-effect transistor and at least one N-type field-effect transistor that are electrically connected to each other, and may be, for example, a 6T memory cell or an 8T memory cell. The at least one P-type field-effect transistor is formed in the front-end-of-line device layer. The at least one N-type field-effect transistor is formed in the back-end-of-line device layer. In this application, the P-type field-effect transistor and the N-type field-effect transistor are three-dimensionally stacked, to improve memory density.

## Description

This application claims priority to Chinese Patent Application No. 202311183082.3, filed with the China National Intellectual Property Administration on September 13, 2023 and entitled "STATIC RANDOM-ACCESS MEMORY ARRAY, MEMORY, AND ELECTRONIC DEVICE", which is incorporated herein by reference in its entirety.

### TECHNICAL FIELD

This application relates to the field of memory technologies, and in particular, to a static random-access memory array, a memory including the static random-access memory, and an electronic device.

### BACKGROUND

A static random-access memory (static random-access memory, SRAM) is a type of random-access memory. "Static" means that stored data can be constantly retained as long as the memory remains powered on. The memory is widely used in computer devices due to its high speed.

In an SRAM production process, for example, for a memory cell including six transistors, these transistors are all made in a silicon substrate by using a front-end-of-line process. Different requirements are imposed on turn-on performance of the six transistors. For example, a requirement on turn-on performance of a pull-down transistor is the highest, turn-on performance of an access transistor is the second highest, and a requirement on turn-on performance of a pull-up transistor is the lowest. A size of the transistor is one of key factors that affect turn-on performance. If sizes of these transistors are reduced to improve memory density, turn-on performance of the transistors and memory performance of the memory are affected.

Therefore, the sizes of the transistors are strictly limited, and the sizes cannot be further reduced with miniaturization of a process node. Consequently, improvement of the memory density of the SRAM is limited.

### SUMMARY

This application provides a static random-access memory array, a production method for the static random-access memory array, a memory, and an electronic device, to provide a static random-access memory array that can improve memory density.

The following technical solutions are used in this application, to achieve the foregoing objective.

According to one aspect, this application provides an SRAM memory array. The SRAM memory array includes a semiconductor substrate, a front-end-of-line device layer, and a back-end-of-line device layer. The front-end-of-line device layer is disposed in the semiconductor substrate. The back-end-of-line device layer is disposed on the front-end-of-line device layer. The SRAM memory array further includes a plurality of memory cells. Each memory cell includes at least one P-type field-effect transistor and at least one N-type field-effect transistor that are electrically connected to each other, and may be, for example, a 3T memory cell, a 6T memory cell, or an 8T memory cell. The at least one P-type field-effect transistor is formed in the front-end-of-line device layer. The at least one N-type field-effect transistor is formed in the back-end-of-line device layer.

The memory cell of the SRAM memory array provided in this application includes the P-type field-effect transistor and the N-type field-effect transistor. The P-type field-effect transistor is made in the front-end-of-line device layer by using a front-end-of-line process. The N-type field-effect transistor is made in the back-end-of-line device layer by using a back-end-of-line process. In contrast, in the conventional technology, all P-type field-effect transistors and N-type field-effect transistors are made by using the front-end-of-line process. In this application, a plurality of field-effect transistors in one memory cell are formed in a three-dimensional stacking manner, to improve memory density and a memory capacity.

In the memory cell, the N-type field-effect transistor may be used as a pull-down transistor on which a higher requirement on turn-on performance is imposed, and is made by using the back-end-of-line process; and the P-type field-effect transistor may be used as a pull-up transistor on which a lower requirement on turn-on performance is imposed, and is made by using the front-end-of-line process. Compared with those in the conventional technology in which all the P-type field-effect transistors and N-type field-effect transistors are made by using the front-end-of-line process, when a same process node is used, high turn-on performance of the pull-down transistor can be ensured, and in this application, more memory cells can be further integrated in a unit area, to improve the memory density.

In an implementation, an orthographic projection of the N-type field-effect transistor on the semiconductor substrate at least partially overlaps an orthographic projection of the P-type field-effect transistor on the semiconductor substrate.

Through use of the process structure, a vertical projection region of a memory cell can be reduced to 2/N of that of an existing structure (all transistors of a memory cell are made by using the front-end-of-line process). The memory density can be significantly improved.

In an implementation, the at least one N-type field-effect transistor includes a first N-type field-effect transistor and a second N-type field-effect transistor, and the first N-type field-effect transistor and the second N-type field-effect transistor are located in a same back-end-of-line device layer.

P-type field-effect transistors are disposed in the same back-end-of-line device layer, and the N-type field-effect transistors are disposed in the front-end-of-line device layer. In this way, a production process of each device layer can be simplified.

In an implementation, the first N-type field-effect transistor and the second N-type field-effect transistor are located in a first back-end-of-line device layer. A first interconnection trace layer is formed between the front-end-of-line device layer and the first back-end-of-line device layer. A second interconnection trace layer is formed on a side that is of the first back-end-of-line device layer and that is away from the first interconnection trace layer. The at least one P-type field-effect transistor includes a first P-type field-effect transistor and a second P-type field-effect transistor. The first P-type field-effect transistor is electrically connected to the second P-type field-effect transistor through the first interconnection trace layer. The first N-type field-effect transistor is electrically connected to the second N-type field-effect transistor through the second interconnection trace layer.

The first P-type field-effect transistor and the second P-type field-effect transistor that are located in the front-end-of-line device layer are electrically connected to each other through the first interconnection trace layer. The first N-type field-effect transistor and the second N-type field-effect transistor that are located in the same back-end-of-line device layer are electrically connected to each other through the second interconnection trace layer.

In an implementation, an orthographic projection of the first N-type field-effect transistor on the semiconductor substrate at least partially overlaps an orthographic projection of the first P-type field-effect transistor on the semiconductor substrate. An orthographic projection of the second N-type field-effect transistor on the semiconductor substrate at least partially overlaps an orthographic projection of the second P-type field-effect transistor on the semiconductor substrate.

In other words, the first N-type field-effect transistor may be located above a vertical projection of the first P-type field-effect transistor, and the second N-type field-effect transistor may be located above a vertical projection of the second P-type field-effect transistor. In this way, projection regions of these transistors on the semiconductor substrate can be reduced, thereby improving the memory density.

In an implementation, a gate of the first P-type field-effect transistor is electrically connected to a first electrode of the second P-type field-effect transistor through the first interconnection trace layer. A gate of the second P-type field-effect transistor is electrically connected to a first electrode of the first P-type field-effect transistor through the first interconnection trace layer. A second electrode of the first P-type field-effect transistor is electrically connected to a second electrode of the second P-type field-effect transistor through the first interconnection trace layer. A gate of the first N-type field-effect transistor is electrically connected to a first electrode of the second N-type field-effect transistor through the second interconnection trace layer. A gate of the second N-type field-effect transistor is electrically connected to a first electrode of the first N-type field-effect transistor through the second interconnection trace layer. A second electrode of the first N-type field-effect transistor is electrically connected to a second electrode of the second N-type field-effect transistor through the second interconnection trace layer. The first electrode is one of a source or a drain, and the second electrode is the other of the source or the drain.

The foregoing provides an example of an implementable electrical connection relationship between four field-effect transistors in a 6T memory cell or an 8T memory cell.

In an implementation, the first electrode of the first P-type field-effect transistor is electrically connected to the first electrode of the first N-type field-effect transistor. The first electrode of the second P-type field-effect transistor is electrically connected to the first electrode of the second N-type field-effect transistor.

In some process structures, through conductive through vias penetrating a dielectric layer, the first electrode of the first P-type field-effect transistor may be interconnected to the first electrode of the first N-type field-effect transistor, and the first electrode of the second P-type field-effect transistor may be interconnected to the first electrode of the second N-type field-effect transistor.

In an implementation, the at least one N-type field-effect transistor further includes a third N-type field-effect transistor and a fourth N-type field-effect transistor. The third N-type field-effect transistor and the fourth N-type field-effect transistor are located in a second back-end-of-line device layer of a same back-end-of-line device layer. The second interconnection trace layer is located between the first back-end-of-line device layer and the second back-end-of-line device layer.

In this way, the 6T memory cell or the 8T memory cell can be formed. In this example, two P-type field-effect transistors in six field-effect transistors are located in the front-end-of-line device layer, the other four N-type field-effect transistors are distributed in two back-end-of-line device layers, and two N-type field-effect transistors are disposed in each back-end-of-line device layer.

For example, both channel materials of the third N-type field-effect transistor and the fourth N-type field-effect transistor may be an oxide semiconductor material.

In an implementation, an orthographic projection of the third N-type field-effect transistor on the semiconductor substrate at least partially overlaps the orthographic projection of the first P-type field-effect transistor on the semiconductor substrate. An orthographic projection of the fourth N-type field-effect transistor on the semiconductor substrate at least partially overlaps the orthographic projection of the second P-type field-effect transistor on the semiconductor substrate.

In this way, a projection region of each memory cell on the semiconductor substrate can be further reduced, thereby improving the memory density and the memory capacity.

In an implementation, a first electrode of the third N-type field-effect transistor is electrically connected to the first electrode of the first N-type field-effect transistor. A first electrode of the fourth N-type field-effect transistor is electrically connected to the first electrode of the second N-type field-effect transistor.

Field-effect transistors located in different device layers may be electrically connected to each other through interconnection trace layers located in the device layers and conductive through vias.

In an implementation, the static random-access memory array further includes a first electrode line, a second electrode line, and a third electrode line. The first electrode of the third N-type field-effect transistor is electrically connected to the first electrode of the first N-type field-effect transistor. The first electrode of the fourth N-type field-effect transistor is electrically connected to the first electrode of the second N-type field-effect transistor. Both a gate of the third N-type field-effect transistor and a gate of the fourth N-type field-effect transistor are electrically connected to the first electrode line. A second electrode of the third N-type field-effect transistor is electrically connected to the second electrode line. A second electrode of the fourth N-type field-effect transistor is electrically connected to the third electrode line. The first electrode line is located in the second back-end-of-line device layer. The second electrode line and the third electrode line are located in a third interconnection trace layer. The second back-end-of-line device layer is located between the second interconnection trace layer and the third interconnection trace layer.

For example, the first electrode line may be a word line, and the second electrode line and the third electrode line may be bit lines.

In an implementation, the at least one N-type field-effect transistor further includes a fifth N-type field-effect transistor and a sixth N-type field-effect transistor. A first electrode of the fifth N-type field-effect transistor is electrically connected to a first electrode of the sixth N-type field-effect transistor. The fifth N-type field-effect transistor and the sixth N-type field-effect transistor are located in a same back-end-of-line device layer.

Such a memory cell may be an 8T memory cell.

In an implementation, the static random-access memory array further includes a fourth electrode line and a fifth electrode line. A second electrode of the sixth N-type field-effect transistor is electrically connected to the fourth electrode line. A gate of the sixth N-type field-effect transistor is electrically connected to the fifth electrode line.

For example, the fourth electrode line is an electrode line RBL, and the fifth electrode line may be an RWL.

In an implementation, the fifth N-type field-effect transistor and the sixth N-type field-effect transistor are located in a third back-end-of-line device layer. The third back-end-of-line device layer is closer to the first back-end-of-line device layer than the second back-end-of-line device layer. A fourth interconnection trace layer is formed between the third back-end-of-line device layer and the second back-end-of-line device layer. The first electrode of the fifth N-type field-effect transistor is electrically connected to the first electrode of the sixth N-type field-effect transistor through the fourth interconnection trace layer. The fifth electrode line is located in the fourth interconnection trace layer. The fourth electrode line is located in the third interconnection trace layer.

In the foregoing provided example, a third back-end-of-line device in which the fifth N-type field-effect transistor and the sixth N-type field-effect transistor are located is located between the second back-end-of-line device layer and the first back-end-of-line device layer. In some other examples, the third back-end-of-line device layer may alternatively be located on the second back-end-of-line device layer.

In an implementation, a channel material of the at least one N-type field-effect transistor includes an oxide semiconductor material.

When an N-type field-effect transistor based on the oxide semiconductor material is made, the oxide semiconductor material may be compatible with the back-end-of-line process, without complicating a production process.

In an implementation, any memory cell includes a first inverter and a second inverter. An input end of the first inverter is electrically connected to an output end of the second inverter. An output end of the first inverter is electrically connected to an input end of the second inverter. The first inverter includes a first P-type field-effect transistor and a first N-type field-effect transistor. The second inverter includes a second P-type field-effect transistor and a second N-type field-effect transistor.

In this example of this application, a memory cell including six field-effect transistors or eight field-effect transistors may be provided. The P-type field-effect transistors in the first inverter and the second inverter in the memory cell are both made by using the front-end-of-line process, and the N-type field-effect transistors are all made by using the back-end-of-line process.

According to another aspect, this application further provides a production method for a static random-access memory array. The production method includes:
forming a front-end-of-line device layer in a semiconductor substrate by using a front-end-of-line process, where at least one P-type field-effect transistor is formed in the front-end-of-line device layer; and
forming a back-end-of-line device layer on the front-end-of-line device layer by using a back-end-of-line process, where at least one N-type field-effect transistor is formed in the back-end-of-line device layer, to make a memory cell that includes the at least one P-type field-effect transistor and the at least one N-type field-effect transistor.

In the production method provided in this application, the P-type field-effect transistor of the memory cell is made by using the front-end-of-line process, and the N-type field-effect transistor of the memory cell is made by using the back-end-of-line process, so that the field-effect transistors of the memory cell are three-dimensionally stacked. In this way, memory density can be improved.

In an implementation, forming the front-end-of-line device layer in the semiconductor substrate by using the front-end-of-line process includes:
forming the front-end-of-line device layer in the semiconductor substrate by using the front-end-of-line process includes:
forming a first P-type field-effect transistor and a second P-type field-effect transistor in the semiconductor substrate by using the front-end-of-line process; and
forming the back-end-of-line device layer on the front-end-of-line device layer by using the back-end-of-line process includes:
   forming a first N-type field-effect transistor and a second N-type field-effect transistor on the front-end-of-line device layer by using the back-end-of-line process, where the first N-type field-effect transistor and the second N-type field-effect transistor are located in a same back-end-of-line device layer, to make a first inverter including the first P-type field-effect transistor and the first N-type field-effect transistor, and a second inverter including the second P-type field-effect transistor and the second N-type field-effect transistor that are electrically connected to each other.

In this way, two cross-coupled inverters in a 6T memory cell or an 8T memory cell can be made.

In an implementation, the first N-type field-effect transistor and the second N-type field-effect transistor are located in a first back-end-of-line device layer. After forming the front-end-of-line device layer and before forming the first back-end-of-line device layer, the production method further includes: forming a first interconnection trace layer, where the first P-type field-effect transistor is electrically connected to the second P-type field-effect transistor through the first interconnection trace layer. After forming the first back-end-of-line device layer, the production method further includes: forming a second interconnection trace layer, where the first N-type field-effect transistor is electrically connected to the second N-type field-effect transistor through the second interconnection trace layer.

The first P-type field-effect transistor and the second P-type field-effect transistor that are located in the front-end-of-line device layer are electrically connected to each other through the first interconnection trace layer. The first N-type field-effect transistor and the second N-type field-effect transistor that are located in the first back-end-of-line device layer are electrically connected to each other through the second interconnection trace layer.

In an implementation, after forming the first N-type field-effect transistor and the second N-type field-effect transistor that are located in the same back-end-of-line device layer, the method further includes: forming a third N-type field-effect transistor and a fourth N-type field-effect transistor that are located in a same back-end-of-line device layer, where the third N-type field-effect transistor is electrically connected to an output end of the first inverter, and the fourth N-type field-effect transistor is electrically connected to an output end of the second inverter.

In this way, the 6T memory cell can be made. In this memory cell, six field-effect transistors can be disposed in the front-end-of-line device layer and two back-end-of-line device layers.

In an implementation, forming the third N-type field-effect transistor and the fourth N-type field-effect transistor that are located in the same back-end-of-line device layer includes: forming a first electrode line, where a gate of the third N-type field-effect transistor and a gate of the fourth N-type field-effect transistor are electrically connected to the first electrode line, and the first electrode line, the third N-type field-effect transistor, and the fourth N-type field-effect transistor are located in the same back-end-of-line device layer.

The first electrode line may be a word line WL.

In an implementation, after forming the third N-type field-effect transistor and the fourth N-type field-effect transistor that are located in the same back-end-of-line device layer, the production method further includes: forming a third interconnection trace layer, where a second electrode line and a third electrode line are formed in the third interconnection trace layer, so that a second electrode of the third N-type field-effect transistor is electrically connected to the second electrode line, and a second electrode of the fourth N-type field-effect transistor is electrically connected to the third electrode line.

The second electrode line and the third electrode line may be respectively a bit line BL and a bit line BLB.

In an implementation, after forming the first N-type field-effect transistor and the second N-type field-effect transistor that are located in the same back-end-of-line device layer, the production method further includes: forming a fifth N-type field-effect transistor and a sixth N-type field-effect transistor that are located in a same back-end-of-line device layer, where a gate of the fifth N-type field-effect transistor is electrically connected to an input end of the first inverter; and a first electrode of the fifth N-type field-effect transistor is electrically connected to a first electrode of the sixth N-type field-effect transistor.

According to another aspect, this application further provides a memory, including a controller and the static random-access memory array according to any one of the foregoing implementations. The controller is electrically connected to the static random-access memory array, and the controller is configured to control read/write on the static random-access memory array.

The memory provided in this application includes the static random-access memory array in the foregoing example. A P-type field-effect transistor of each memory cell in the static random-access memory array is integrated into a front-end-of-line device layer, and an N-type field-effect transistor is integrated into a back-end-of-line device layer, so that a plurality of field-effect transistors of the memory cell are three-dimensionally stacked, thereby improving memory density of the memory.

According to another aspect, this application further provides an electronic device, including a processor and the foregoing memory. The processor is electrically connected to the memory, and the memory is configured to store data generated by the processor.

The electronic device provided in this embodiment of this application includes the memory according to any one of the foregoing implementations. Therefore, the electronic device provided in this embodiment of this application and the memory in the foregoing technical solutions can resolve a same technical problem and achieve same expected effect.

### BRIEF DESCRIPTION OF DRAWINGS

FIG. 1 is a circuit schematic of an electronic device;
FIG. 2 is a circuit schematic of a memory;
FIG. 3A is a diagram of a packaging structure of a memory array and a controller;
FIG. 3B is a diagram of a packaging structure of a memory array and a controller;
FIG. 3C is a diagram of a packaging structure of a memory array and a controller;
FIG. 4 is a simple circuit schematic of a memory;
FIG. 5 is a circuit schematic of a 6T memory cell according to an embodiment of this application;
FIG. 6 is a circuit schematic of an 8T memory cell according to an embodiment of this application;
FIG. 7 is a diagram of a simple process structure of a memory array according to an embodiment of this application;
FIG. 8A is a layout of a front-end-of-line device layer of a memory array according to an embodiment of this application;
FIG. 8B and FIG. 8C are layouts of a back-end-of-line device layer of a memory array according to an embodiment of this application;
FIG. 9A is a layout of a front-end-of-line device layer of a memory array according to an embodiment of this application;
FIG. 9B, FIG. 9C, and FIG. 9D are layouts of a back-end-of-line device layer of a memory array according to an embodiment of this application; and
FIG. 10 is a block flowchart of a production method for a memory array according to an embodiment of this application.

### DESCRIPTION OF EMBODIMENTS

Before embodiments provided in this application are described, related technical terms are first described.

Pull-up means to clamp a signal to a high level.

Pull-down means to clamp a signal to a low level.

An oxide semiconductor (oxide semiconductor) is a type of oxide having a semiconductor characteristic.

The following describes the following various embodiments of this application with reference to accompanying drawings in embodiments of this application.

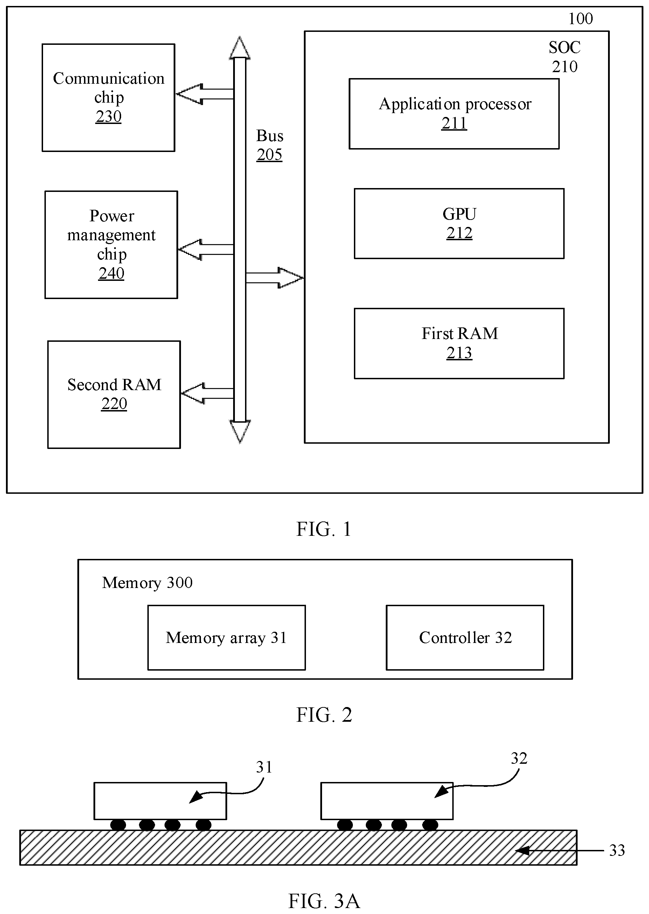

Technical solutions of this application may be applied to various electronic devices using a memory. For example, FIG. 1 is a block circuit schematic of an electronic device 100 according to an embodiment of this application. The electronic device 100 may be a terminal device, for example, a mobile phone, a tablet computer, or a smart band, or may be a personal computer (personal computer, PC), a server, a workstation, or the like.

As shown in FIG. 1, the electronic device 100 may include a bus 205 and a system on chip (system on chip, SOC) 210 connected to the bus 205. The SOC 210 may be configured to process data, for example, process data of an application, process image data, and cache temporary data. In an implementation, the SOC 210 may include an application processor (application processor, AP) 211 configured to process an application, a graphics processing unit (graphics processing unit, GPU) 212 configured to process image data, and a first random-access memory (random-access memory, RAM) 213 configured to cache high-speed data. The first RAM 213 may be a static random-access memory (static random-access memory, SRAM), an embedded flash (embedded flash, eflash), or the like. The AP 211, the GPU 212, and the first RAM 213 may be integrated into one die (die), or may be respectively disposed in a plurality of dies.

Still as shown in FIG. 1, the electronic device 100 may further include a second RAM 220 connected to the SOC 210 through the bus 205. The second RAM 220 may be a dynamic random-access memory (dynamic random-access memory, DRAM). The second RAM 220 may be configured to store volatile data, for example, temporary data generated by the SOC 210. A memory capacity of the second RAM 220 is usually greater than that of the first RAM 213, but a read speed of the second RAM 220 is usually less than that of the first RAM 213.

In addition, the electronic device 100 may further include a communication chip 230 and a power management chip 240 that are connected to the SOC 210 through the bus 205. The communication chip 230 may be configured to process a protocol stack, or perform processing such as amplification and filtering on an analog radio frequency signal, or implement the foregoing functions. The power management chip 240 may be configured to supply power to another chip. In an implementation, the SOC 210 and the second RAM 220 may be packaged in one packaging structure through, for example, 2.5D (dimensional) or 3D packaging, to obtain a faster inter-chip data transmission rate.

As shown in FIG. 2, a memory 300 includes a memory array 31 and a controller 32 configured to access the memory array 31. The controller 32 is configured to control a read/write operation on the memory array 31.

The memory array 31 and the controller 32 shown in FIG. 2 have a plurality of implementable packaging structures. For example, the following provides several implementable packaging structures.

FIG. 3A shows a packaging structure of the memory array 31 and the controller 32 according to an embodiment of this application. To be specific, the memory array 31 and the controller 32 are two chips independent of each other, and the memory array 31 and the controller 32 are separately integrated on a base board 33. For example, the memory array 31 and the controller 32 may be electrically connected to each other through a metal trace disposed on the base board 33. In this structure, because the memory array 31 and the controller 32 are two independent chips, the memory array 31 may be referred to as a stand-alone (stand-alone) memory.

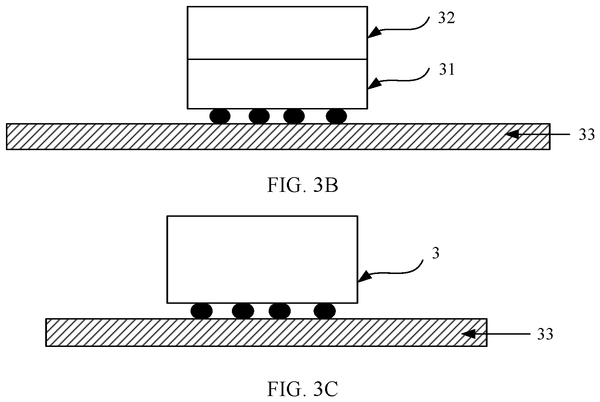

FIG. 3B shows another packaging structure of the memory array 31 and the controller 32 according to an embodiment of this application. In this structure, similar to those in FIG. 3A, the memory array 31 and the controller 32 are two chips independent of each other. Therefore, the memory array 31 may also be referred to as a stand-alone memory. Different from those in FIG. 3A, in FIG. 3B, the memory array 31 and the controller 32 are stacked. For example, the memory array 31 and the controller 32 may be connected to each other through a through silicon via (through silicon via, TSV) or a redistribution layer (redistribution layer, RDL).

FIG. 3C shows another packaging structure of the memory array 31 and the controller 32 according to an embodiment of this application. In this example structure, the memory array 31 and the controller 32 are integrated into a same chip 3, and the chip 3 is integrated on a base board 33. Therefore, the memory array 31 may be referred to as an embedded memory.

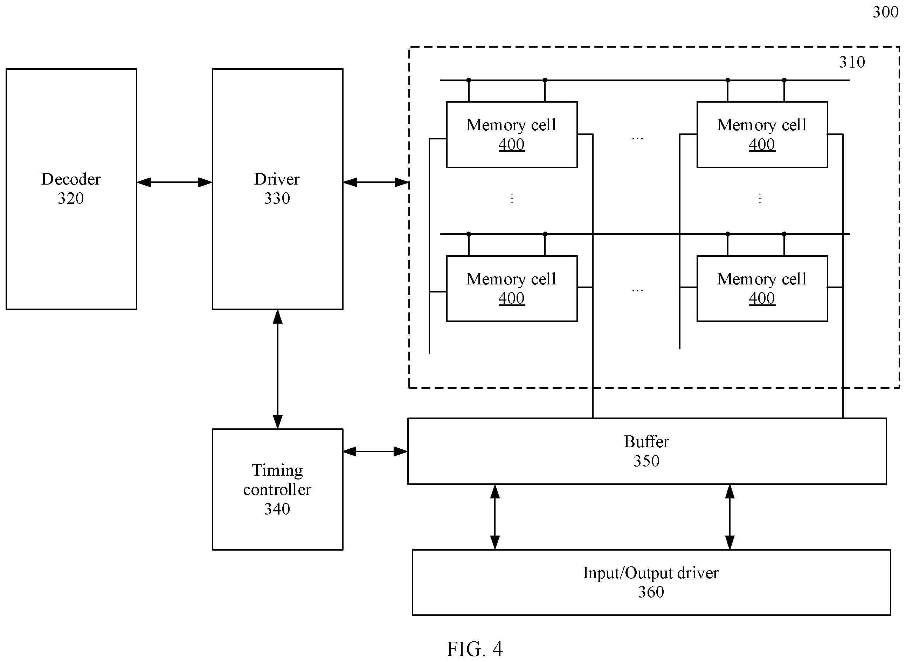

In an implementation, the memory array 31 in the memory may include a plurality of memory cells 400 arranged in an array shown in FIG. 4, and each memory cell 400 may be configured to store 1-bit (bit) or multi-bit data. The memory array 31 may further include electrode lines such as a word line (word line, WL) and a bit line (bit line, BL). Each memory cell 400 is electrically connected to a corresponding word line WL and a corresponding bit line BL. Different memory cells 400 may be electrically connected through word lines WLs and bit lines BLs. One or more of the word lines WLs and the bit lines BLs are configured to select a to-be-read/written memory cell 400 in the memory array by receiving a control level output by a control circuit, to implement a data read/write operation.

The controller 32 in the memory may include one or more circuit structures of a decoder 320, a driver 330, a timing controller 340, a buffer 350, or an input/output driver 360 shown in FIG. 4.

In the structure of the memory 300 shown in FIG. 4, the decoder 320 is configured to perform decoding based on a received address, to determine a memory cell 400 that needs to be accessed. The driver 330 is configured to control a level of a signal line based on a decoding result generated by the decoder 320, to implement access to a specified memory cell 400. The buffer 350 is configured to buffer read data, for example, may buffer the data using first-in first-out (first-in first-out, FIFO). The timing controller 340 is configured to: control timing of the buffer 350, and control the driver 330 to drive the signal line in the memory array 310. The input/output driver 360 is configured to drive a transmission signal, for example, drive a received data signal and drive a data signal that needs to be sent, so that the data signals can be transmitted over a long distance.

The memory array 310, the decoder 320, the driver 330, the timing controller 340, the buffer 350, and the input/output driver 360 may be integrated into one chip, or may be respectively integrated into a plurality of chips.

In some examples, the memory 300 may be electrically connected to a processor, and the memory is configured to store data generated by the processor.

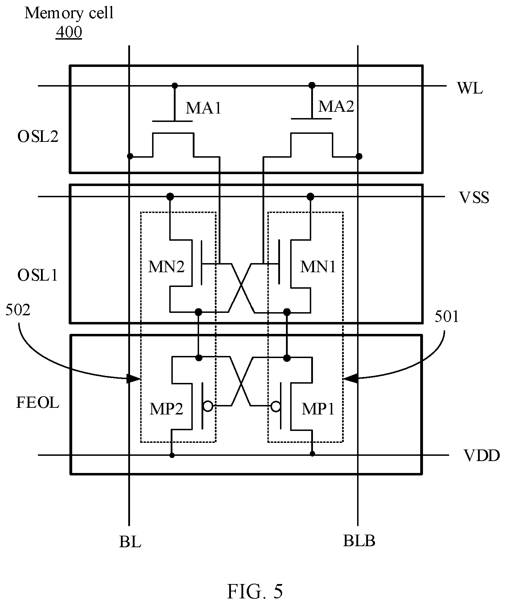

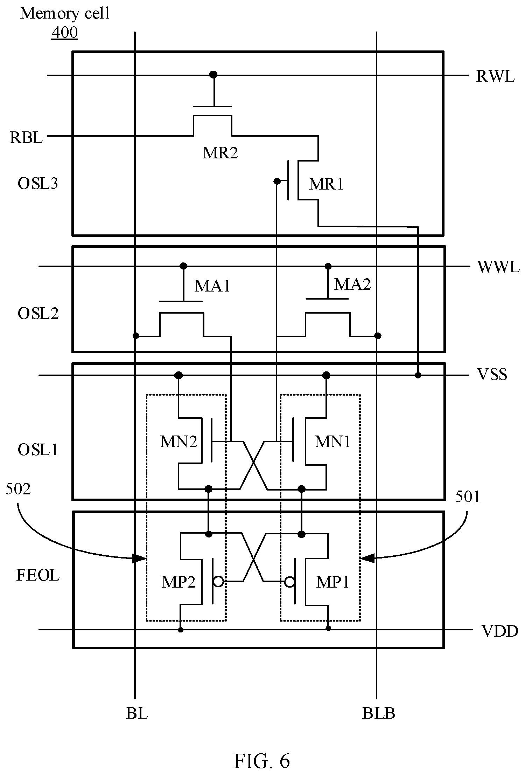

The memory in this embodiment of this application may include a memory cell of a static random-access memory array shown in FIG. 5 or FIG. 6. A memory cell 400 of the static random-access memory array shown in FIG. 5 includes six field-effect transistors (Oxide semiconductor based Field-Effect Transistor, OS-FET), and may be referred to as a 6T memory cell. A memory cell 400 of the static random-access memory array shown in FIG. 6 includes eight field-effect transistors, and may be referred to as an 8T memory cell.

In some other examples, a memory cell may be a 3T memory cell, a 4T memory cell, a 5T memory cell, a 7T memory cell, a 9T memory cell, a 10T memory cell, or a memory cell including more field-effect transistors.

In this embodiment of this application, a memory cell of the static random-access memory array includes at least three field-effect transistors, and the at least three field-effect transistors may include a P-type field-effect transistor and an N-type field-effect transistor.

For example, the 6T memory cell 400 shown in FIG. 5 includes a field-effect transistor MP1, a field-effect transistor MN1, a field-effect transistor MP2, a field-effect transistor MN2, a field-effect transistor MA1, and a field-effect transistor MA2. The field-effect transistor MP1 and the field-effect transistor MP2 are P-type field-effect transistors, and the rest are N-type field-effect transistors.

For another example, the 8T memory cell 400 shown in FIG. 6 includes a field-effect transistor MP1, a field-effect transistor MN1, a field-effect transistor MP2, a field-effect transistor MN2, a field-effect transistor MA1, and a field-effect transistor MA2, and further includes a field-effect transistor MR1 and a field-effect transistor MR2. The field-effect transistor MP1 and the field-effect transistor MP2 are P-type field-effect transistors, and the rest are N-type field-effect transistors.

In some examples provided in this application, as shown in FIG. 5 and FIG. 6, the P-type field-effect transistors are made in a semiconductor substrate by using a front-end-of-line (front end of line, FEOL) process. For example, the field-effect transistor MP1 and the field-effect transistor MP2 in FIG. 5 and FIG. 6 are made by using the front-end-of-line FEOL process, and the remaining N-type field-effect transistors are made in a back-end-of-line device layer by using a back-end-of-line (Back end of line, BEOL) process.

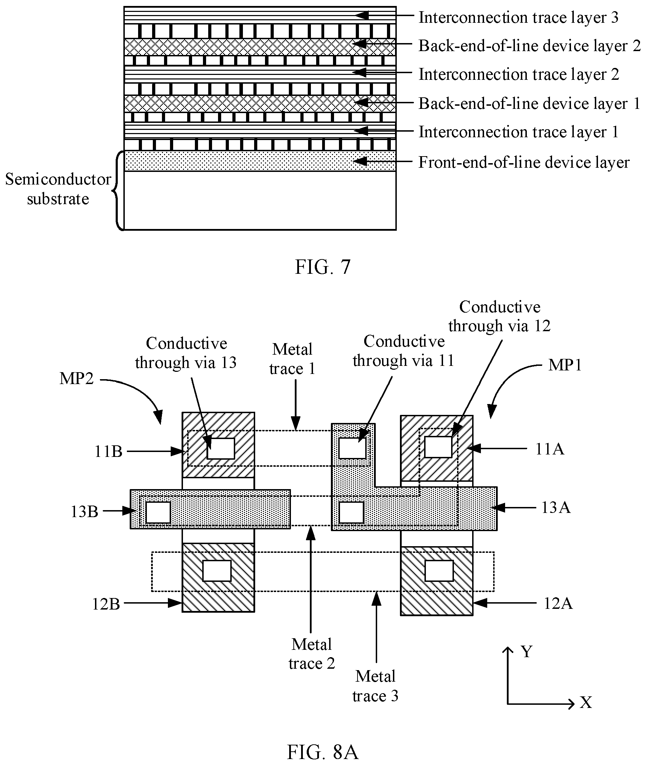

In this example of this application, that the P-type field-effect transistor is made in the semiconductor substrate by using the front-end-of-line FEOL process and the N-type field-effect transistor is made in the back-end-of-line device layer by using the back-end-of-line process may be understood as follows: As shown in FIG. 7, in a chip production process, the front-end-of-line device layer may be first made in the semiconductor substrate by using the front-end-of-line process, where electronic devices in the front-end-of-line device layer may include the P-type field-effect transistors shown in FIG. 5 and FIG. 6, and a source and a drain of the P-type field-effect transistor may be formed in the semiconductor substrate through doping; and after the front-end-of-line device layer is made, the back-end-of-line device layer may be made by using the back-end-of-line process, for example, the N-type field-effect transistors shown in FIG. 5 and FIG. 6 may be formed in the back-end-of-line device layer by using the back-end-of-line process.

As shown in FIG. 7, the N-type field-effect transistors shown in FIG. 5 and FIG. 6 may be integrated into the back-end-of-line device layer. An interconnection trace layer is configured to: form a metal trace and electrically connect electronic devices in the back-end-of-line device layer. The back-end-of-line device layer is isolated from the interconnection trace layer by using a dielectric layer, and the back-end-of-line device layer and the interconnection trace layer may be electrically connected to each other through a conductive through via (for example, a through silicon via) penetrating the dielectric layer.

A channel material of the N-type field-effect transistor located in the back-end-of-line device layer in this example of this application includes an oxide semiconductor material, and the oxide semiconductor material may include at least one of ZnO, CdO, TiO₂, Al₂O₃, and SnO. Alternatively, the channel material of the N-type field-effect transistor may include polycrystalline silicon.

An oxide semiconductor based field-effect transistor (Oxide semiconductor based Field-Effect Transistor, OS-FET) process may be compatible with the back-end-of-line process, that is, an active device, namely, the N-type field-effect transistor, may be disposed in the back-end-of-line device layer, without complicating a production process.

As shown in FIG. 5 and FIG. 6, a plurality of field-effect transistors in one memory cell are formed in a three-dimensional stacking manner, to form a three-dimensionally stacked memory (3-Dimensional Memory, 3D Memory). Compared with a case in which all field-effect transistors in one memory cell are made by using the front-end-of-line process, this application can significantly improve memory density.

In this example of this application, the P-type field-effect transistor that may be used as a pull-up transistor is made by using the front-end-of-line process, and the N-type field-effect transistor that may be used as a pull-down transistor is made by using the back-end-of-line process. Compared with a case in which an existing P-type field-effect transistor and an existing N-type field-effect transistor are both made by using the front-end-of-line process, when a same process node is used, this application can ensure high turn-on performance of the pull-down transistor, and further improve the memory density.

In this application, a 6T memory cell and an 8T memory cell are used as examples to describe an implementable process structure of the memory cell.

As shown in FIG. 5 and FIG. 6, a 6T memory cell 400 or an 8T memory cell 400 includes a first inverter 501 and a second inverter 502. An input end of the first inverter 501 is electrically connected to an output end of the second inverter 502, an output end of the first inverter 501 is electrically connected to an input end of the second inverter 502, and the first inverter 501 and the second inverter 502 form a cross-coupled circuit structure.

The first inverter 501 includes the field-effect transistor MP1 and the field-effect transistor MN1 that are electrically connected to each other. The second inverter 502 includes the field-effect transistor MP2 and the field-effect transistor MN2 that are electrically connected to each other.

The field-effect transistor MP1 and the field-effect transistor MP2 are separately disposed in the semiconductor substrate by using the front-end-of-line process, and are located in the front-end-of-line device layer in the semiconductor substrate. The field-effect transistor MN1 and the field-effect transistor MN2 are separately made in the back-end-of-line device layer on the semiconductor substrate by using the back-end-of-line process.

To further improve the memory density, as shown in FIG. 5 and FIG. 6, the field-effect transistor MP1 and the field-effect transistor MP2 are located in the front-end-of-line device layer, and the field-effect transistor MN1 and the field-effect transistor MN2 may be disposed in a same back-end-of-line device layer, for example, an OSL1 device layer shown in FIG. 5 and FIG. 6.

In some examples, in the field-effect transistor MN1 and the field-effect transistor MN2 that are N-type field-effect transistors, channels may be made of an oxide semiconductor material. The field-effect transistor MN1 and the field-effect transistor MN2 are disposed in the same back-end-of-line device layer, so that the memory density can be improved. The production process can be further simplified because channel materials are the same.

In some implementable process structures, in the first inverter 501, the field-effect transistor MN1 is formed, by using the back-end-of-line process, on a side that is of the field-effect transistor MP1 and that is away from the semiconductor substrate. In some examples, orthographic projections of the field-effect transistor MN1 and the field-effect transistor MP1 on the semiconductor substrate partially overlap. In the second inverter 502, the field-effect transistor MN2 is formed, by using the back-end-of-line process, on a side that is of the field-effect transistor MP2 and that is away from the semiconductor substrate. In some examples, orthographic projections of the field-effect transistor MN2 and the field-effect transistor MP2 on the semiconductor substrate partially overlap. In this way, an area of an orthographic projection of each memory cell on the semiconductor substrate can be further reduced, thereby further improving the memory density.

With reference to FIG. 5 and FIG. 6, a gate of the field-effect transistor MP1 is electrically connected to a first electrode of the field-effect transistor MP2, a gate of the field-effect transistor MP2 is electrically connected to a first electrode of the field-effect transistor MP1, and a second electrode of the field-effect transistor MP1 is electrically connected to a second electrode of the field-effect transistor MP2. For example, both the second electrode of the field-effect transistor MP1 and the second electrode of the field-effect transistor MP2 may be electrically connected to VDD.

A gate of the field-effect transistor MN1 is electrically connected to a first electrode of the field-effect transistor MN2, a gate of the field-effect transistor MN2 is electrically connected to a first electrode of the field-effect transistor MN1, and a second electrode of the field-effect transistor MN1 is electrically connected to a second electrode of the field-effect transistor MN2. For example, both the second electrode of the field-effect transistor MN1 and the second electrode of the field-effect transistor MN2 may be electrically connected to VSS.

The first electrode of the field-effect transistor MP1 is electrically connected to the first electrode of the field-effect transistor MN1, and the electrical connection node forms an output end of the first inverter 501. The gate of the field-effect transistor MP1 is electrically connected to the gate of the field-effect transistor MN1, and the electrical connection node forms an input end of the first inverter 501.

The first electrode of the field-effect transistor MP2 is electrically connected to the first electrode of the field-effect transistor MN2, and the electrical connection node forms an output end of the second inverter 502. The gate of the field-effect transistor MP2 is electrically connected to the gate of the field-effect transistor MN2, and the electrical connection node forms an input end of the second inverter 502.

In this example of this application, the first electrode is one of a source or a drain, and the second electrode is the other of the source or the drain.

With reference to a diagram of a process structure, the following describes in detail an implementable process structure of the field-effect transistors in the first inverter 501 and the second inverter 502, and a process connection structure between different electrodes.

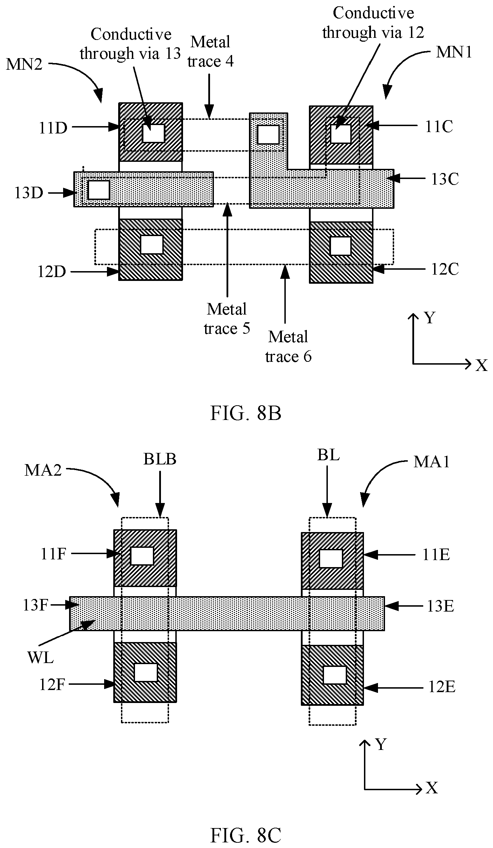

FIG. 8A, FIG. 8B, and FIG. 8C show layout structures of device layers according to an embodiment of this application.

A memory array includes the front-end-of-line device layer, an interconnection trace layer 1, a back-end-of-line device layer 1, an interconnection trace layer 2, a back-end-of-line device layer 2, and an interconnection trace layer 3 that are stacked in FIG. 7.

As shown in FIG. 8A, the field-effect transistor MP1 and the field-effect transistor MP2 are arranged in a first direction (for example, an X direction) parallel to a surface of the semiconductor substrate (not shown in the figure).

In the first inverter 501, as shown in FIG. 8A, a first electrode 11A and a second electrode 12A of the field-effect transistor MP1 are arranged in a second direction (for example, a Y direction) parallel to the surface of the semiconductor substrate, and a channel of the field-effect transistor MP1 is formed between the first electrode 11A and the second electrode 12A. A gate 13A of the field-effect transistor MP1 is disposed above the channel, and may be isolated from the channel by using a gate dielectric layer.

In the second inverter 502, as shown in FIG. 8A, a first electrode 11B and a second electrode 12B of the field-effect transistor MP2 are arranged in the second direction, and a channel of the field-effect transistor MP2 is formed between the first electrode 11B and the second electrode 12B. A gate 13B of the field-effect transistor MP2 is disposed above the channel, and may be isolated from the channel by using a gate dielectric layer.

A source, a drain, and the channel of the field-effect transistor MP1 are located in the front-end-of-line device layer. A source, a drain, and the channel of the field-effect transistor MP2 are also located in the front-end-of-line device layer. In some examples, the sources and the drains of the field-effect transistor MP1 and the field-effect transistor MP2 may be made in an ion injection manner.

Because the field-effect transistor MP1 and the field-effect transistor MP2 need to be electrically connected to each other, in some process structures, the interconnection trace layer 1 may be disposed on the front-end-of-line device layer in the semiconductor substrate. For example, as shown in FIG. 8A, the gate 13A of the field-effect transistor MP1 is electrically connected to the first electrode 11B of the field-effect transistor MP2 through a metal trace 1, the gate 13B of the field-effect transistor MP2 is electrically connected to the first electrode 11A of the field-effect transistor MP1 through a metal trace 2, and the second electrode 12A of the field-effect transistor MP1 is electrically connected to the second electrode 12B of the field-effect transistor MP2 through a metal trace 3. The metal trace 1, the metal trace 2, and the metal trace 3 are some traces in the interconnection trace layer 1.

There is a dielectric layer between the front-end-of-line device layer and the interconnection trace layer 1. A metal trace may be electrically connected to a corresponding structure through a conductive through via (for example, a through silicon via) penetrating the dielectric layer. For example, the gate 13A of the field-effect transistor MP1 may be connected to the metal trace 1 through a conductive through via 11.

In the front-end-of-line device layer, a plurality of field-effect transistors MP1 and field-effect transistors MP2 are integrated. These field-effect transistors MP1 and field-effect transistors MP2 are arranged in an array. To electrically connect a second electrode of a field-effect transistor MP1 and a second electrode of a field-effect transistor MP2 that are located in a same direction, as shown in FIG. 8A, the metal trace 3 may extend in the X direction, to electrically connect second electrodes of a plurality of field-effect transistors MP1 and second electrodes of a plurality of field-effect transistors MP2 that are located in the X direction. For example, the metal trace 3 may be electrically connected to VDD.

Both the field-effect transistor MN1 of the first inverter 501 and the field-effect transistor MN2 of the second inverter 502 are disposed in the back-end-of-line device layer 1. As shown in FIG. 8B, the field-effect transistor MN1 and the field-effect transistor MN2 are arranged in the X direction.

As shown in FIG. 8B, in the first inverter 501, a first electrode 11C and a second electrode 12C of the field-effect transistor MN1 are arranged in the Y direction. In this example of this application, the field-effect transistor MN1 is an example of a ring gate structure. In some other examples, a ring channel structure may alternatively be used.

As shown in FIG. 8B, in the second inverter 502, a first electrode 11D and a second electrode 12D of the field-effect transistor MN2 are also arranged in the Y direction. Examples of the field-effect transistor MN2 and the field-effect transistor MN1 are similar, and are both ring gate structures, or other structures may be used.

An orthographic projection of the field-effect transistor MN1 on the semiconductor substrate at least partially overlaps an orthographic projection of the field-effect transistor MP1 on the semiconductor substrate, that is, the field-effect transistor MN1 is located above a vertical projection of the field-effect transistor MP1. An orthographic projection of the field-effect transistor MN2 on the semiconductor substrate at least partially overlaps an orthographic projection of the field-effect transistor MP2 on the semiconductor substrate, that is, the field-effect transistor MN2 is located above a vertical projection of the field-effect transistor MP2. In this way, areas of orthographic projections of the first inverter and the second inverter in the memory cell on the semiconductor substrate may be reduced by half compared with those in the conventional technology, thereby improving the memory density and a memory capacity.

As shown in FIG. 7 and FIG. 8B, the interconnection trace layer 2 is disposed on the back-end-of-line device layer 1, and the field-effect transistor MN1 may be electrically connected to the field-effect transistor MN2 through the interconnection trace layer 2.

For example, a gate 13C of the field-effect transistor MN1 is electrically connected to the first electrode 11D of the field-effect transistor MN2 through a metal trace 4, a gate 13D of the field-effect transistor MN2 is electrically connected to the first electrode 11C of the field-effect transistor MN1 through a metal trace 5, and the second electrode 12C of the field-effect transistor MN1 is electrically connected to the second electrode 12D of the field-effect transistor MN2 through a metal trace 6. The metal trace 4, the metal trace 5, and the metal trace 6 are some traces in a second interconnection trace layer.

There is a dielectric layer between the back-end-of-line device layer 1 and the interconnection trace layer 2. A metal trace in the interconnection trace layer 2 may be electrically connected to a corresponding structure in the back-end-of-line device layer 1 through a conductive through via penetrating the dielectric layer.

The field-effect transistor MP1 located in the front-end-of-line device layer needs to be electrically connected to the field-effect transistor MN1 located in the back-end-of-line device layer. The field-effect transistor MP2 located in the front-end-of-line device layer needs to be electrically connected to the field-effect transistor MN2 located in the back-end-of-line device layer.

The first electrode 11A of the field-effect transistor MP1 is electrically connected to the first electrode 11C of the field-effect transistor MN1. In some examples, the first electrode 11A and the first electrode 11C may be interconnected through a conductive through via penetrating the dielectric layer.

The first electrode 11B of the field-effect transistor MP2 is electrically connected to the first electrode 11D of the field-effect transistor MN2. In some structures, the first electrode 11B and the first electrode 11D may be interconnected through a conductive through via 13 penetrating the dielectric layer.

In some other process structures, the first electrode 11A is interconnected to the first electrode 11C, and the first electrode 11B is interconnected to the first electrode 11D. Alternatively, another tracing manner may be used.

The 6T memory cell shown in FIG. 5 and the 8T memory cell shown in FIG. 6 further include the field-effect transistor MA1 and the field-effect transistor MA2. The field-effect transistor MA1 and the field-effect transistor MA2 may be N-type field-effect transistors, and may be made by using the back-end-of-line process. For example, channel materials of the field-effect transistor MA1 and the field-effect transistor MA2 include an oxide semiconductor material.

In some examples, the field-effect transistor MA1 and the field-effect transistor MA2 may be formed in a same back-end-of-line device layer by using the back-end-of-line process, for example, located in an OSL2 device layer shown in FIG. 5 and FIG. 6.

The field-effect transistor MA2 is electrically connected to the output end of the first inverter 501, and the field-effect transistor MA1 is electrically connected to the output end of the second inverter 502.

The field-effect transistor MA1 and the field-effect transistor MA2 are disposed in the back-end-of-line device layer 2.

As shown in FIG. 8C, the field-effect transistor MA1 and the field-effect transistor MA2 are arranged in the X direction.

As shown in FIG. 8C, a first electrode 11E and a second electrode 12E of the field-effect transistor MA1 are arranged in the Y direction. In this example of this application, the field-effect transistor MA1 is an example of a ring gate structure. In some other examples, a ring channel structure may alternatively be used.

As shown in FIG. 8C, a first electrode 11F and a second electrode 12F of the field-effect transistor MA2 are also arranged in the Y direction. Examples of the field-effect transistor MA2 and the field-effect transistor MA1 are similar, and are both ring gate structures, or other structures may be used.

As shown in FIG. 8C, a gate 13E of the field-effect transistor MA1 is electrically connected to a gate 13F of the field-effect transistor MA2.

For example, the first electrode of the field-effect transistor MA2 is electrically connected to the gate of the field-effect transistor MN1, or the first electrode of the field-effect transistor MA2 is electrically connected to the first electrode of the field-effect transistor MN2.

The first electrode of the field-effect transistor MA1 is electrically connected to the gate of the field-effect transistor MN2, or the first electrode of the field-effect transistor MA1 is electrically connected to the first electrode of the field-effect transistor MN1.

Still with reference to the 6T memory cell in the example, six field-effect transistors in a memory cell are distributed in three device layers, where two P-type field-effect transistors are disposed in the front-end-of-line device layer, and the other four N-type field-effect transistors are disposed in two back-end-of-line device layers. In this way, a memory cell can be made by using the three three-dimensionally stacked device layers, and an interconnection between different field-effect transistors is implemented through an interconnection trace layer disposed between two adjacent device layers.

The 6T memory cell shown in FIG. 5 further includes an electrode line configured to control read/write on the memory cell, for example, includes a word line WL, a first bit line BL, and a second bit line BLB. The second electrode of the field-effect transistor MA1 is electrically connected to the first bit line BL, the second electrode of the field-effect transistor MA2 is electrically connected to the second bit line BLB, and both the gate of the field-effect transistor MA1 and the gate of the field-effect transistor MA2 are electrically connected to the word line WL.

In an implementable process structure, the interconnection trace layer 3 is disposed on the back-end-of-line device layer 2 in which the field-effect transistor MA1 and the field-effect transistor MA2 are located, the first bit line BL and the second bit line BLB are located in the interconnection trace layer 3, and the word line WL is located in the back-end-of-line device layer 2.

In some examples provided in this application, the first bit line BL and the second bit line BLB may be parallel to each other, and the word line WL may be perpendicular to both the first bit line BL and the second bit line BLB.

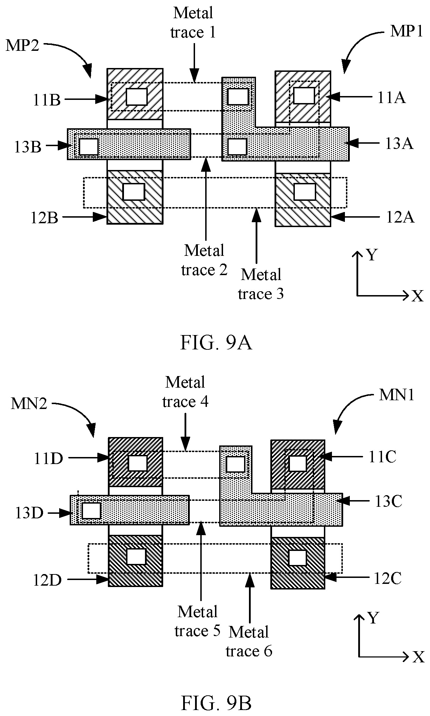

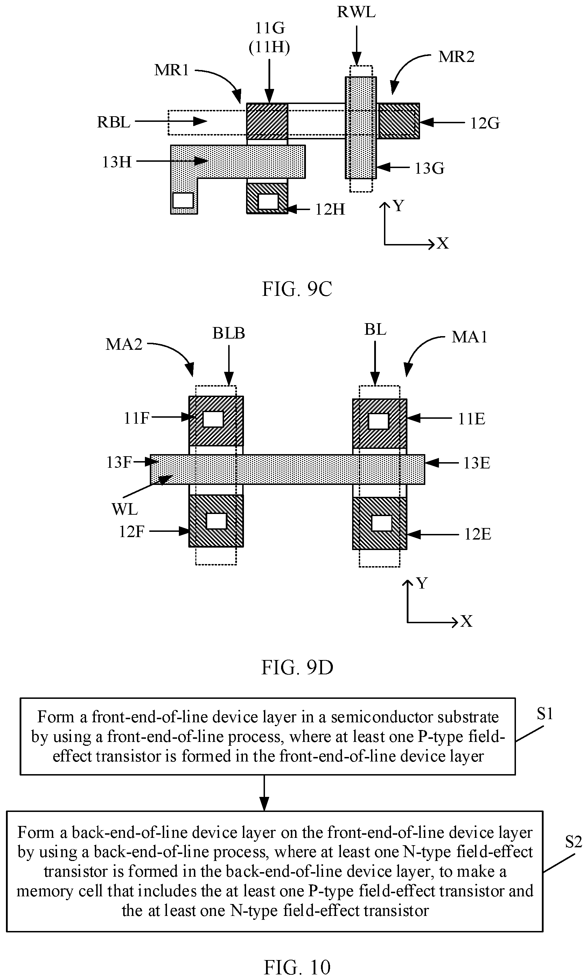

FIG. 8A to FIG. 8C are diagrams of the process structure of the 6T memory cell. FIG. 9A to FIG. 9D are layouts of an 8T memory cell according to this application.

A memory array shown in FIG. 9A to FIG. 9D includes a front-end-of-line device layer, an interconnection trace layer 1, a back-end-of-line device layer 1, an interconnection trace layer 2, a back-end-of-line device layer 2, an interconnection trace layer 3, a back-end-of-line device layer 3, and an interconnection trace layer 4 that are stacked in FIG. 7.

This example is the same as the foregoing example. Each memory cell includes a field-effect transistor MP1, a field-effect transistor MN1, a field-effect transistor MP2, a field-effect transistor MN2, a field-effect transistor MA1, and a field-effect transistor MA2.

The field-effect transistor MP1 and the field-effect transistor MP2 are located in the front-end-of-line device layer. The field-effect transistor MN1 and the field-effect transistor MN2 are located in the back-end-of-line device layer 1. The field-effect transistor MP1 and the field-effect transistor MP2 are electrically connected to each other through the interconnection trace layer 1. The field-effect transistor MN1 and the field-effect transistor MN2 are electrically connected to each other through the interconnection trace layer 2.

The 8T memory cell shown in this application further includes the field-effect transistor MA1, the field-effect transistor MA2, a field-effect transistor MR1, and a field-effect transistor MR2. In some examples, as shown in FIG. 6, the field-effect transistor MA1 and the field-effect transistor MA2 are disposed in an OSL2 device layer, and the field-effect transistor MR1 and the field-effect transistor MR2 may be disposed in an OSL3 device layer.

In some other examples, the field-effect transistor MR1 and the field-effect transistor MR2 may be located in the OSL2 device layer, and the field-effect transistor MA1 and the field-effect transistor MA2 may be located in the OSL3 device layer. For example, the field-effect transistor MR1 and the field-effect transistor MR2 are disposed in the back-end-of-line device layer 2, and the field-effect transistor MA1 and the field-effect transistor MA2 are disposed in the back-end-of-line device layer 3.

In the process structure of the 8T memory cell shown in this application, for an implementable process structure of the field-effect transistor MP1, the field-effect transistor MN1, the field-effect transistor MP2, and the field-effect transistor MN2, and a process connection structure between electrodes, refer to those in the foregoing 6T memory cell.

FIG. 9C shows an example of a layout of a process structure of the field-effect transistor MR1 and the field-effect transistor MR2. A first electrode 11G and a second electrode 12G of the field-effect transistor MR2 are arranged in an X direction. A first electrode 11H and a second electrode 12H of the field-effect transistor MR1 are arranged in a Y direction. The first electrode 11G of the field-effect transistor MR2 and the first electrode 11H of the field-effect transistor MR1 share a same electrode layer, to implement an electrical connection between the first electrode 11G and the first electrode 11H.

FIG. 9C shows the process structure of an electrical connection between the field-effect transistor MR1 and the field-effect transistor MR2. In some other examples, an interconnection trace layer is disposed on the back-end-of-line device layer in which the field-effect transistor MR1 and the field-effect transistor MR2 are located, and the first electrode 11G and the first electrode 11H may be electrically connected to each other through a metal trace located in the interconnection trace layer.

The memory array further includes an electrode line RBL and an electrode line RWL. The second electrode of the field-effect transistor MR2 is electrically connected to the electrode line RBL, and a gate of the field-effect transistor MR2 is electrically connected to the electrode line RWL. The second electrode 12H of the field-effect transistor MR1 may be electrically connected to VSS.

The electrode line RWL electrically connected to the gate of the field-effect transistor MR2 may be located in the interconnection trace layer 3.

The electrode line RBL electrically connected to the second electrode of the field-effect transistor MR2 may be disposed in the interconnection trace layer 4 located above the field-effect transistor MA1 and the field-effect transistor MA2, that is, the first bit line BL, the second bit line BLB, and four electrode lines RBLs may be disposed in a same interconnection trace layer. In some examples, the first bit line BL, the second bit line BLB, and the electrode line RBL may also be disposed in parallel to each other. The electrode line RWL may be arranged perpendicular to the electrode line RBL.

An embodiment of this application further provides a production method for a static random-access memory array. FIG. 10 shows an example of a block flowchart of the production method for a static random-access memory array. The production method includes the following steps.

Step S1: Form a front-end-of-line device layer in a semiconductor substrate by using a front-end-of-line process, where at least one P-type field-effect transistor is formed in the front-end-of-line device layer.

In some implementable processes, the P-type field-effect transistor may be made by using a doping process.

Step S2: Form a back-end-of-line device layer on the front-end-of-line device layer by using a back-end-of-line process, where at least one N-type field-effect transistor is formed in the back-end-of-line device layer, to make a memory cell that includes the at least one P-type field-effect transistor and the at least one N-type field-effect transistor.

In this application, the N-type field-effect transistor is made by using the back-end-of-line process. In some examples, the N-type field-effect transistor may be made of an oxide semiconductor material compatible with the back-end-of-line process. The oxide semiconductor material may include at least one of ZnO, CdO, TiO2, Al2O3, and SnO.

In some production processes, a memory cell may include more field-effect transistors, and is, for example, a 6T memory cell or an 8T memory cell.

In each memory cell of an SRAM memory array that is made by using the production method provided in this application, a P-type field-effect transistor is made in the front-end-of-line device layer, and an N-type field-effect transistor is made in a back-end-of-line interconnection layer. In other words, a plurality of field-effect transistors of the memory cell are integrated on the semiconductor substrate in a three-dimensional stacking manner, so that memory density can be improved.

For example, when a 6T memory cell is made, a plurality of P-type field-effect transistors (for example, a pull-down transistor in the memory cell) disposed in an array may be first made in the semiconductor substrate by using the front-end-of-line process; then an interconnection trace layer used to electrically connect the P-type field-effect transistors is made by using the back-end-of-line process; then a plurality of N-type field-effect transistors (for example, a pull-up transistor in the memory cell) disposed in an array are made by using the back-end-of-line process; an interconnection trace layer used to electrically connect the N-type field-effect transistors is made; then a plurality of N-type field-effect transistors (for example, a gating transistor in the memory cell) are made by using the back-end-of-line process; and an interconnection trace layer used to electrically connect the N-type field-effect transistors is made.

In this application, for example, a 6T memory cell is made. When step S1 is performed, a first P-type field-effect transistor and a second P-type field-effect transistor in the 6T memory cell are made, where the first P-type field-effect transistor and the second P-type field-effect transistor may be arranged in a direction parallel to a surface of the semiconductor substrate. When step S2 is performed, a first N-type field-effect transistor and a second N-type field-effect transistor in the 6T memory cell are made, where the first P-type field-effect transistor and the first N-type field-effect transistor may form a first inverter, and the second P-type field-effect transistor and the second N-type field-effect transistor may form a second inverter.

Before the first N-type field-effect transistor and the second N-type field-effect transistor are made, an interconnection trace layer may be made, to electrically connect a plurality of P-type field-effect transistors located in the front-end-of-line device layer, for example, electrically connect the first P-type field-effect transistor to the second P-type field-effect transistor.

After the first P-type field-effect transistor and the second P-type field-effect transistor are made, an interconnection trace layer may be made, to electrically connect a plurality of N-type field-effect transistors located in the front-end-of-line device layer, for example, electrically connect the first N-type field-effect transistor to the second N-type field-effect transistor.

After the first inverter and the second inverter are made, a third N-type field-effect transistor and a fourth N-type field-effect transistor in the 6T memory cell may be further made, so that the third N-type field-effect transistor and the fourth N-type field-effect transistor are located in a same back-end-of-line device layer. In addition, a word line WL, a first bit line BL, and a second bit line BLB are made.

In some examples, an 8T memory cell may be made by using the foregoing process of making the 6T memory cell, where two N-type field-effect transistors are formed in each back-end-of-line device layer.

In the descriptions of this specification, the specific features, structures, materials, or characteristics may be combined in an appropriate manner in any one or more of embodiments or examples.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A static random-access memory array, comprising:
a semiconductor substrate; and
a front-end-of-line device layer and a back-end-of-line device layer, wherein the front-end-of-line device layer is disposed in the semiconductor substrate, and the back-end-of-line device layer is disposed on the front-end-of-line device layer, wherein
the static random-access memory array further comprises a plurality of memory cells, and each memory cell comprises at least one P-type field-effect transistor and at least one N-type field-effect transistor;
the at least one P-type field-effect transistor is formed in the front-end-of-line device layer; and
the at least one N-type field-effect transistor is formed in the back-end-of-line device layer.

2. The static random-access memory array according to claim 1, wherein
an orthographic projection of the N-type field-effect transistor on the semiconductor substrate at least partially overlaps an orthographic projection of the P-type field-effect transistor on the semiconductor substrate.

3. The static random-access memory array according to claim 1 or 2, wherein
the at least one N-type field-effect transistor comprises a first N-type field-effect transistor and a second N-type field-effect transistor, and the first N-type field-effect transistor and the second N-type field-effect transistor are located in a same back-end-of-line device layer.

4. The static random-access memory array according to claim 3, wherein
the first N-type field-effect transistor and the second N-type field-effect transistor are located in a first back-end-of-line device layer;
a first interconnection trace layer is formed between the front-end-of-line device layer and the first back-end-of-line device layer;
a second interconnection trace layer is formed on a side that is of the first back-end-of-line device layer and that is away from the first interconnection trace layer;
the at least one P-type field-effect transistor comprises a first P-type field-effect transistor and a second P-type field-effect transistor;
the first P-type field-effect transistor is electrically connected to the second P-type field-effect transistor through the first interconnection trace layer; and
the first N-type field-effect transistor is electrically connected to the second N-type field-effect transistor through the second interconnection trace layer.

5. The static random-access memory array according to claim 4, wherein
an orthographic projection of the first N-type field-effect transistor on the semiconductor substrate at least partially overlaps an orthographic projection of the first P-type field-effect transistor on the semiconductor substrate; and
an orthographic projection of the second N-type field-effect transistor on the semiconductor substrate at least partially overlaps an orthographic projection of the second P-type field-effect transistor on the semiconductor substrate.

6. The static random-access memory array according to claim 4 or 5, wherein
a gate of the first P-type field-effect transistor is electrically connected to a first electrode of the second P-type field-effect transistor through the first interconnection trace layer;
a gate of the second P-type field-effect transistor is electrically connected to a first electrode of the first P-type field-effect transistor through the first interconnection trace layer;
a second electrode of the first P-type field-effect transistor is electrically connected to a second electrode of the second P-type field-effect transistor through the first interconnection trace layer;
a gate of the first N-type field-effect transistor is electrically connected to a first electrode of the second N-type field-effect transistor through the second interconnection trace layer;
a gate of the second N-type field-effect transistor is electrically connected to a first electrode of the first N-type field-effect transistor through the second interconnection trace layer;
a second electrode of the first N-type field-effect transistor is electrically connected to a second electrode of the second N-type field-effect transistor through the second interconnection trace layer; and
the first electrode is one of a source or a drain, and the second electrode is the other of the source or the drain.

7. The static random-access memory array according to any one of claims 4 to 6, wherein
the first electrode of the first P-type field-effect transistor is electrically connected to the first electrode of the first N-type field-effect transistor; and
the first electrode of the second P-type field-effect transistor is electrically connected to the first electrode of the second N-type field-effect transistor.

8. The static random-access memory array according to any one of claims 4 to 7, wherein
the at least one N-type field-effect transistor further comprises a third N-type field-effect transistor and a fourth N-type field-effect transistor;
the third N-type field-effect transistor and the fourth N-type field-effect transistor are located in a second back-end-of-line device layer of a same back-end-of-line device layer;
the second interconnection trace layer is located between the first back-end-of-line device layer and the second back-end-of-line device layer;
an orthographic projection of the third N-type field-effect transistor on the semiconductor substrate at least partially overlaps the orthographic projection of the first P-type field-effect transistor on the semiconductor substrate; and
an orthographic projection of the fourth N-type field-effect transistor on the semiconductor substrate at least partially overlaps the orthographic projection of the second P-type field-effect transistor on the semiconductor substrate.

9. The static random-access memory array according to claim 8, wherein
the static random-access memory array further comprises a first electrode line, a second electrode line, and a third electrode line;
a first electrode of the third N-type field-effect transistor is electrically connected to the first electrode of the first N-type field-effect transistor;
a first electrode of the fourth N-type field-effect transistor is electrically connected to the first electrode of the second N-type field-effect transistor;
both a gate of the third N-type field-effect transistor and a gate of the fourth N-type field-effect transistor are electrically connected to the first electrode line;
a second electrode of the third N-type field-effect transistor is electrically connected to the second electrode line;
a second electrode of the fourth N-type field-effect transistor is electrically connected to the third electrode line;
the first electrode line is located in the second back-end-of-line device layer;
the second electrode line and the third electrode line are located in a third interconnection trace layer; and
the second back-end-of-line device layer is located between the second interconnection trace layer and the third interconnection trace layer.

10. The static random-access memory array according to claim 8 or 9, wherein
the at least one N-type field-effect transistor further comprises a fifth N-type field-effect transistor and a sixth N-type field-effect transistor;
a first electrode of the fifth N-type field-effect transistor is electrically connected to a first electrode of the sixth N-type field-effect transistor; and
the fifth N-type field-effect transistor and the sixth N-type field-effect transistor are located in a same back-end-of-line device layer.

11. The static random-access memory array according to claim 10, wherein
the static random-access memory array further comprises a fourth electrode line and a fifth electrode line;
a second electrode of the sixth N-type field-effect transistor is electrically connected to the fourth electrode line; and
a gate of the sixth N-type field-effect transistor is electrically connected to the fifth electrode line.

12. The static random-access memory array according to claim 11, wherein the fifth N-type field-effect transistor and the sixth N-type field-effect transistor are located in a third back-end-of-line device layer, and the third back-end-of-line device layer is closer to the first back-end-of-line device layer than the second back-end-of-line device layer;
a fourth interconnection trace layer is formed between the third back-end-of-line device layer and the second back-end-of-line device layer;
the first electrode of the fifth N-type field-effect transistor is electrically connected to the first electrode of the sixth N-type field-effect transistor through the fourth interconnection trace layer;
the fifth electrode line is located in the fourth interconnection trace layer; and
the fourth electrode line is located in the third interconnection trace layer.

13. The static random-access memory array according to any one of claims 1 to 12, wherein a channel material of the at least one N-type field-effect transistor comprises an oxide semiconductor material.

14. A production method for a static random-access memory array, wherein the production method comprises:
forming a front-end-of-line device layer in a semiconductor substrate by using a front-end-of-line process, wherein at least one P-type field-effect transistor is formed in the front-end-of-line device layer; and
forming a back-end-of-line device layer on the front-end-of-line device layer by using a back-end-of-line process, wherein at least one N-type field-effect transistor is formed in the back-end-of-line device layer, to make a memory cell that comprises the at least one P-type field-effect transistor and the at least one N-type field-effect transistor.

15. The production method for a static random-access memory array according to claim 14, wherein
forming the back-end-of-line device layer on the front-end-of-line device layer by using the back-end-of-line process comprises:
making the N-type field-effect transistor in the back-end-of-line device layer, so that an orthographic projection of the N-type field-effect transistor on the semiconductor substrate at least partially overlaps an orthographic projection of the P-type field-effect transistor on the semiconductor substrate.

16. The production method for a static random-access memory array according to claim 14 or 15, wherein
forming the front-end-of-line device layer in the semiconductor substrate by using the front-end-of-line process comprises:
forming a first P-type field-effect transistor and a second P-type field-effect transistor in the semiconductor substrate by using the front-end-of-line process; and
forming a back-end-of-line interconnection layer on the front-end-of-line device layer by using the back-end-of-line process comprises:
forming a first N-type field-effect transistor and a second N-type field-effect transistor on the front-end-of-line device layer by using the back-end-of-line process, wherein the first N-type field-effect transistor and the second N-type field-effect transistor are located in a same back-end-of-line device layer, to make a memory cell that comprises the first P-type field-effect transistor, the first N-type field-effect transistor, the second P-type field-effect transistor, and the second N-type field-effect transistor.

17. The production method for a static random-access memory array according to claim 16, wherein
the first N-type field-effect transistor and the second N-type field-effect transistor are located in a first back-end-of-line device layer;
after forming the front-end-of-line device layer and before forming the first back-end-of-line device layer, the production method further comprises:
forming a first interconnection trace layer, wherein the first P-type field-effect transistor is electrically connected to the second P-type field-effect transistor through the first interconnection trace layer; and
after forming the first back-end-of-line device layer, the production method further comprises:
forming a second interconnection trace layer, wherein the first N-type field-effect transistor is electrically connected to the second N-type field-effect transistor through the second interconnection trace layer.

18. The production method for a static random-access memory array according to claim 16 or 17, wherein
after forming the first N-type field-effect transistor and the second N-type field-effect transistor that are located in the same back-end-of-line device layer, the method further comprises:
forming a third N-type field-effect transistor and a fourth N-type field-effect transistor that are located in a same back-end-of-line device layer.

19. A memory, comprising:
the static random-access memory array according to any one of claims 1 to 13, or a memory array made by using the production method for a static random-access memory array according to any one of claims 14 to 18; and
a controller, wherein the controller is electrically connected to the static random-access memory array, and the controller is configured to control read/write on the static random-access memory array.

20. An electronic device, comprising:
a processor; and
the memory according to claim 19, wherein the processor is electrically connected to the memory, and the memory is configured to store data generated by the processor.
